# EUROPÄISCHE PATENTSCHRIFT

(11) **EP 0 499 607 B1**
(45) Veröffentlichungstag und Bekanntmachung des Hinweises auf die Patenterteilung: **13.07.1994**
(21) Anmeldenummer: 90914066.7
(22) Anmeldetag: 04.10.1990
(51) Int. Cl.: H05K 5/00, H05K 5/02

(54) **GEHÄUSE FÜR EINE ELEKTRONISCHE SCHALTUNG**
HOUSING FOR ELECTRONIC CIRCUITRY
BOITIER POUR CIRCUIT ELECTRONIQUE

(30) Priorität: 08.11.1989 DE 3937190
(43) Veröffentlichungstag der Anmeldung: 26.08.1992
(73) Patentinhaber: ROBERT BOSCH GMBH, 70442 Stuttgart (DE)
(72) Erfinder: KLINGER, Herbert, D-8500 Nürnberg 60 (DE); THOMAS, Gerhard, D-8510 Fürth (DE); WUTZ, Karl, D-8430 Neumarkt (DE)
(86) Internationale Anmeldenummer: DE9000749
(87) Internationale Veröffentlichungsnummer: WO9107865

(56) Entgegenhaltungen:
- EP-A- 0 125 619
- EP-A- 0 353 443
- DE-U- 7 141 337
- FR-A- 2 334 268

## Beschreibung

### Stand der Technik

Die Erfindung betrifft ein Gehäuse für eine elektronische Schaltung, insbesondere für eine Steuergerätelektronik einer Brennkraftmaschine eines Fahrzeugs, mit einem Schaltungs-Aufnahmeraum und einer Anschlußvorrichtung für eine losbare elektrische Verbindung von Informations- und Versorgungsleitungen.

Für die Funktionsfähigkeit einer elektronischen Schaltung ist es z.B. in der Fahrzeugtechnik oftmals entscheidend, diese in einem gegenüber der Umwelt dichten Gehäuse unterzubringen, so daß keine Feuchtigkeit und dergleichen eindringen kann. Der Anschlußbereich von Informations- und Versorgungsleitungen stellt eine besondere Schwachstelle in bezug auf die Dichtigkeit dar. Des weiteren ist die Funktionssicherheit von der elektromagnetischen Verträglichkeit (EMV) der elektronischen Schaltung abhängig, d. h., das Gehäuse sollte eine hinreichend große Abschirmwirkung entfalten. Gleichzeitig wird ein einfacher Aufbau und eine hohe Service- und Diagnosefreundlichkeit angestrebt.

Aus der DE-OS 25 54 747 geht ein Gehäuse für ein elektronisches Steuergerät hervor, das aus einer elektronischen Leiterplatte und einem Deckel bestehende Wandungen aufweist. Leiterplatte und Deckel sind miteinander vernietet. Die Nietverbindung erschwert die Zugänglichkeit zur elektronischen Schaltung.

Aus DE-U-7141337 ist ein Gehäuse für eine elektronische Schaltung bekannt, das alle im Oberbegriff des Anspruchs 1 genannten Merkmale aufweist.

### Vorteile der Erfindung

Das erfindungsgemäße Gehäuse mit den im Hauptanspruch genannten Merkmalen hat demgegenüber den Vorteil, daß bei einer hermetisch dichten und sicheren Ausbildung eine hohe Service- und Diagnosefreundlichkeit gegeben ist. Das Gehäuse besteht aus zwei voneinander trennbaren Gehäuseteilen, die unterschiedliche Aufgaben übernehmen. Das eine, erste Gehäuseteil weist einen Schaltungs-Aufnahmeraum auf, in der die elektronische Schaltung anordbar ist. Das andere, zweite Gehäuseteil dient der elektrischen Verbindung mit von außen kommenden Informations- und Versorgungsleitungen. Durch die trennbare Ausgestaltung beider Gehäuseteile ist eine gute Zugänglichkeit und damit eine hohe Service- und Diagnosefreundlichkeit realisiert. Aufgrund der Trennung der Elektronik von der Anschlußvorrichtung für die Informations- und Versorgungsleitungen besteht ein hoher Dichtigkeitsschutz, so daß ein derartiges Gehäuse an einem Fahrzeug sogar für eine Freimontage geeignet ist. Selbst wenn Feuchtigkeit oder dergleichen durch die Leitungsdurchführungen in das zweite Gehäuseteil zur Anschlußvorrichtung gelangen sollte, bleibt die elektronische Schaltung durch das separate erste Gehäuseteil davon verschont.

Vorzugsweise sind die beiden Gehäuseteile über ein Scharnier miteinander verbunden. Dieses führt zu einer besonders hohen Wartungsfreundlichkeit, da durch Aufklappen der beiden Gehäuseteile auch an sich schwer erreichbare Stellen leicht zugänglich werden.

Eine weitere Schutzbarriere ergibt sich dadurch, daß das zweite Gehäuseteil einen Anschlußraum für die Anschlußvorrichtung und einen Verteilerraum aufweist. Der Anschlußraum ist von dem Verteilerraum vorzugsweise durch eine Trennwand abgeteilt, die von Kontaktanschlüssen der abgedichteten Anschlußvorrichtung durchsetzt werden. Die Trennwand bildet somit nochmals eine Feuchtigkeitssperre. Nach einem bevorzugten Ausführungsbeispiel kann der Anschlußraum einen mit Labyrinth-Dichtung versehenen Ausgang aufweisen, der zwar eine Belüftung gestattet und über die Kabeldurchführungen möglicherweise eingetretene Feuchtigkeit ableitet, jedoch keine Feuchtigkeit eindringen läßt. Durch den separierten Anschlußraum ist es möglich, der elektronischen Schaltung nicht direkt angehörende, jedoch ebenfalls feuchtigkeitsempfindliche Bauelemente, wie z.B. Relais, Sicherungen und Diagnose-Leuchtdioden im zweiten Gehäuseteil, und zwar im Verteilerraum, anzuordnen. Eine Auswertung der Diagnose-Leuchtdioden läßt möglicherweise einen Fehler erkennen, ohne daß ein Öffnen des Schaltungs-Aufnahmeraums erforderlich ist.

Die Kontaktanschlüsse der abgedichteten Anschlußvorrichtung führen vorzugsweise direkt zu einer im Verteilerraum angeordneten Platine. Dieses führt nicht nur zu einem einfachen Aufbau, sondern auch zu einer hohen Funktionssicherheit.

Insbesondere ist vorgesehen, daß die beiden Gehäuseteile zwei Gehäuseebenen bilden. In der einen Ebene befindet sich dann die elektronische Schaltung und die andere Ebene dient der Anschluß- und Verteilerfunktion.

Gemäß einem Ausführungsbeispiel weist das zweite Gehäuseteil eine wannenförmige Gestalt auf und ist mit der Bodenwand des ersten Gehäuseteils verschließbar. Damit trennt die Bodenwand den Schaltungs-Aufnahmeraum sowohl von dem Anschlußraum als auch von dem Verteilerraum ab. Beim Öffnen des Gehäuses bleibt der Schaltung-Aufnahmeraum noch verschlossen, während Anschluß- und Verteilerraum zugänglich sind.

Für einen hermetischen Abschluß können an den beiden Gehäuseteilen Dichtungen vorgesehen sein.

Nach einem bevorzugten Ausführungsbeispiel ist die Bodenwand des ersten Gehäuseteils herausnehmbar ausgebildet. Das Scharnier gestattet ein Auseinanderklappen beider Gehäuseteile, wobei in dieser aufgeklappten Stellung die Bodenwand entnehmbar ist. In der aufgeklappten Stellung sind alle Komponenten bequem zugänglich. Für die Abdichtung des Schaltung-Aufnahmeraums ist die Bodenwand vorzugsweise über Dichtungen mit dem übrigen ersten, ebenfalls wannenförmigen Gehäuseteil verbunden. Das Scharnier verbindet vorzugsweise die beiden wannenförmigen Gehäuseteile, greift also nicht an der Bodenwand an.

Nach einem anderen Ausführungsbeispiel ist auch die Bodenwand bei der Bildung des Scharniers beteiligt. Sowohl das erste Gehäuseteil als auch die Bodenwand weisen Fortsätze auf, die beide zusammen -im zusammengefügten Zustand von Bodenwand und Gehäuseteileine Scharniergabel bilden, die an einem Scharnierzapfen des zweiten Gehäuseteils angreift. Die Außenseite des der Bodenwand zugeordneten Fortsatzes liegt bei der Betätigung des Scharniers, bei der das erste Gehäuseteil zusammen mit der Bodenwand relativ zum zweiten Gehäuseteil verschwenkt wird, einer formangepaßten Lagerfläche des zweiten Gehäuseteils gegenüber, so daß erst ab einem bestimmten Öffnungswinkel eine Freigabe erfolgt, indem die Maulöffnung der Scharniergabel den Durchtritt des Scharnierzapfens gestattet.

Sofern die Scharnierhälften des Scharniers in Offenstellung voneinander gelöst werden können, kann das Gehäuse auch zerlegt werden. Dieses ist inbesondere für den Austausch von ganzen Komponenten, wie z. B. das mit elektronischer Schaltung versehene erste Gehäuseteil, vorteilhaft.

Zum einfachen Trennen und Zusammenfügen der beiden Gehäuseteile kann eine vom Verteilerraum zum Schaltungs-Aufnahmeraum führende, abgedichtete elektrische Steckverbindung vorgesehen sein. Diese weist ein Kontakt- und ein Gegenkontaktelement auf, wobei das Kontaktelement über eine flexible, zugentlastete Leitung an die im Verteilerraum angeordnete Platine angeschlossen ist.

Eine besonders hohe Funktionssicherheit stellt sich ein, wenn das Gegenkontaktelement in einem elektrisch abgeschirmten Vorraum des ersten Gehäuseteils angeordnet ist. Der Vorraum kann ferner störstrahlungsträchtige Bauelemente aufnehmen. Die sich im Schaltungs-Aufnahmeraum befindende elektronische Schaltung unterliegt daher keiner funktionsmindernden Störeinstrahlung.

Insbesondere ist vorgesehen, daß die Informations- und Versorgungsleitungen über eine abgedichtete, zugentlastete Kabeleinführung in den Anschlußraum geführt sind. Hierdurch ist auch die Anschlußvorrichtung für die lösbare elektrische Verbindung der Informations- und Versorgungsleitungen gegen Korrosion und dergleichen geschützt. Vorzugsweise erfolgt der Anschluß der Informations- und Versorgungsleitungen über Steckverbinder.

Die Gehäuseteile sind insbesondere als metallische Druckgußteile ausgebildet. Dieses gilt ebenfalls für die Bodenwand und die Trennwände zwischen Anschluß- und Verteilerraum sowie Vorraum und Schaltungs-Aufnahmeraum. Vorzugsweise ist auch die Kabeleinführung als Druckgußteil hergestellt.

### Zeichnung

Die Erfindung wird im folgenden anhand der Figuren näher erläutert. Es zeigen:
Figur 1 einen Längsschnitt durch ein Gehäuse für eine elektronische Schaltung,

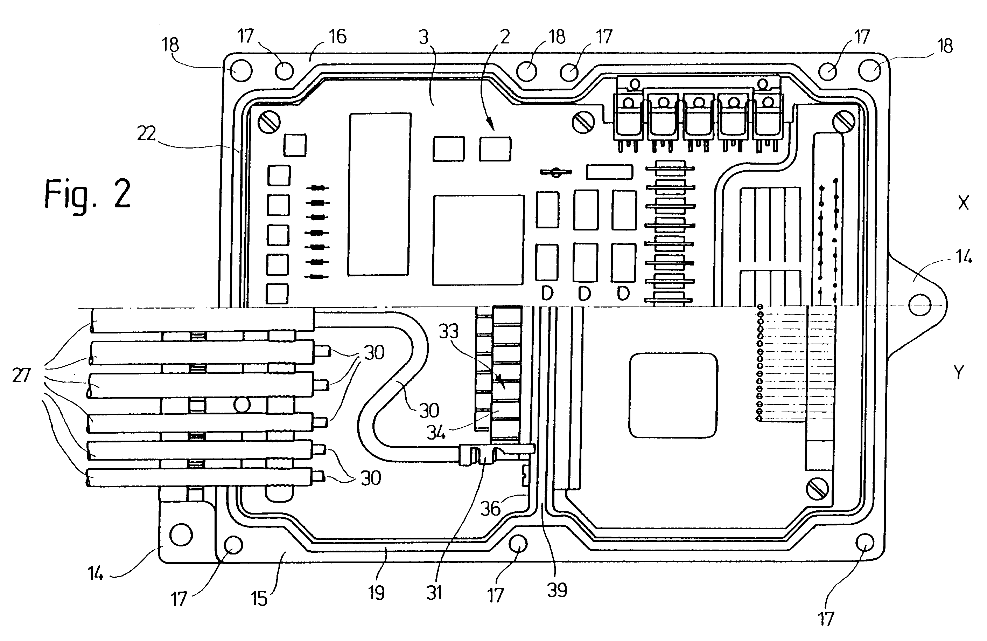

Figur 2 eine Draufsicht auf das Gehäuse der Figur 1 in der Ansicht des Pfeiles x sowie des Pfeiles y und
Figur 3 eine Detailansicht eines Scharniers des Gehäuses.

### Beschreibung eines Ausführungsbeispiels

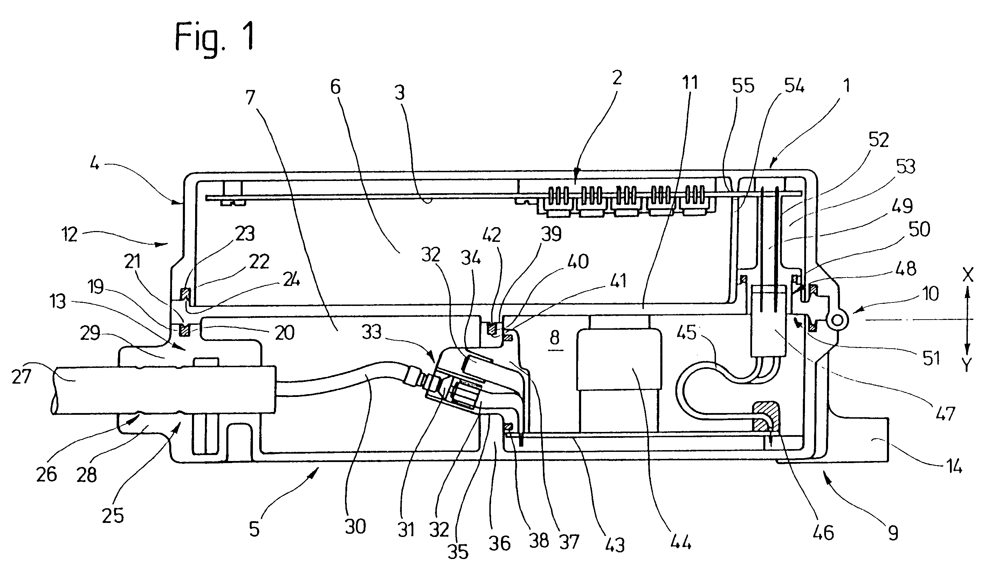

Die Figur 1 zeigt ein Gehäuse 1 für eine elektronische Schaltung 2, die als Steuergerätelektronik einer Brennkraftmaschine eines Fahrzeugs ausgebildet ist. Die elektronische Schaltung 2 ist auf einer Leiterplatte 3 angeordnet.

Das Gehäuse 1 setzt sich aus zwei voneinander trennbaren Gehäuseteilen 4 und 5 zusammen, wovon das eine, erste Gehäuseteil 4 einen Schaltungs-Aufnahmeraum 6 und das andere, zweite Gehäuseteil 5 einen Anschlußraum 7 und einen Verteilerraum 8 aufweist. Beide Gehäuseteile 4 und 5 sind als wannenförmige, metallische Druckgußteile hergestellt. Sie stehen über ein an einem Seitenrand 9 des Gehäuses 1 angeordnetes Scharnier 10 schwenkbeweglich miteinander in Verbindung. Im geschlossenen Zustand liegen sich die beiden wannenförmigen Gehäuseteile 4 und 5 mit ihren Aufnahmeöffnungen gegenüber, wobei zwischen ihnen eine Bodenwand 11 des ersten Gehäuseteiles 4 angeordnet ist, die gleichzeitig eine Deckenwandung für das zweite Gehäuseteil 5 bildet. Mithin bilden die beiden Gehäuseteile 4 und 5 zwei Gehäuseebenen 12 und 13. In der Gehäuseebene 12 liegt der Schaltungs-Aufnahmeraum 6 und in der Gehäuseebene 13 sind Anschlußraum 7 und Verteilerraum 8 angeordnet.

Das zweite Gehäuseteil 5 bildet somit ein Unterteil des Gehäuses 1 und ist mit Befestigungsflanschen 14 für seine Montage versehen. Beide Gehäuseteile 4 und 5 weisen am Wannenrand ausgebildete, umlaufende Flanschkragen 15 bzw. 16 auf, die mit Gewindebohrungen 17 bzw. Durchgangslöchern 18 für nicht dargestellte Gewindeschrauben versehen sind, mit denen die beiden Gehäuseteile 4 und 5 verspannt werden können. Das Gehäuseteil 5 weist am Flanschkragen 15 eine umlaufende Nut 19 für eine Dichtung 20 auf, die von einem Ringsteg 21 der Bodenwand 11 beaufschlagt wird.

Ebenso ist am Flanschkragen 16 des Gehäuseteils 1 eine umlaufende Nut 22 vorgesehen, die eine Dichtung 23 aufnimmt, welche mit einem auf der anderen Seite der Bodenwand 11 angeordneten Ringsteg 24 zusammenwirkt.

Die eine Seitenwand 25 des Anschlußraums 7 ist als Kabeleinführung 26 für Informations- und Versorgungsleitungen 27 ausgebildet. Die Kabeleinführung 26 besteht aus einem einstückig mit dem Gehäuseteil 5 verbundenem Unterteil 28, das mit einem Druckstück 29 verspannbar ist. Durch das Verspannen von Unterteil 28 und Druckstück 29 wird eine Zugentlastung für die Informations- und Versorgungsleitungen 27 gebildet. Das Druckstück 29 bildet einen Wandungsbereich des Gehäuseteils 5. Vorzugsweise ist die Kabeleinführung 26 mit einer an den Mantelwänden der Informations- und Versorgungsleitungen 27 angreifenden Dichtung versehen, so daß ein Feuchtigkeitseintritt in den Anschlußraum 7 verhindert ist.

Die Adern 30 der Informations- und Versorungsleitungen 27 sind über Steckverbinder 31 mit Kontaktanschlüssn 32 einer Anschlußvorrichtung 33 verbunden. Diese durchgreift mit ihrem Anschlußbereich 34 einen Durchbruch 35 einer einstückig am Gehäuseteil 5 ausgebildeten Trennwand 36, die den Anschlußraum 7 von dem Verteilerraum 8 abteilt. Die Anschlußvorrichtung 33 weist einen Flanschbereich 37 auf, der mit einer Dichtung 38 versehen ist und gegen die dem Verteilerraum 8 zugewandte Seite der Trennwand 36 anliegt. Die Stirnseite 39 der Trennwand 36 ist mit einer Nut 40 versehen, die in die Nut 19 einmündet und eine Dichtung 41 trägt, die mit einem Steg 42 der Bodenwand 11 zusammenwirkt.

Die Kontaktanschlüsse 32 der Anschlußvorrichtung 33 sind direkt mit Leiterbahnen einer im Verteilerraum 8 angeordneten Platine 43 verbunden, die Relais 44 sowie nicht dargestellte Sicherung und Diagnose-Leuchtdioden und dergleichen aufnimmt. An die Platine 43 sind flexible Leitungen 45 angeschlossen, die von einer Zugentlastung 46 gehalten werden. Die Leitungen 45 führen zu einem Kontaktelement 47, einer elektrischen Steckverbindung 48. Das Kontaktelement 47 ist mit einem Gegenkontaktelement 49 zusammengesteckt, das mittels einer Dichtung 50 hermetisch abgeschlossen in einem Durchbruch 51 der Bodenwand 11 sitzt.

Mit seinem Anschlußbereich 52 liegt das Gegenkontaktelement 49 in einem elektrisch abgeschirmten Vorraum 53 des Gehäuseteils 4, der vom Schaltungs-Aufnahmeraum 6 durch eine einstückig mit dem Gehäuseteil 4 ausgebildeten Querwand 54 abgetrennt ist. Die Leiterplatte 3 der elektronischen Schaltung 2 durchgreift einen Schlitz 55 der Querwand 54, so daß die Kontaktfahnen des Gegenkontaktelements 49 direkt mit den Leiterbahnen der Leiterplatte 3 verbunden werden können. Der Vorraum 53 nimmt überdies nicht dargestellte störstrahlungsträchtige Bauelemente auf.

Durch Lösen der die beiden Gehäuseteile 4 und 5 verspannenden Gewindeschrauben läßt sich das Gehäuse 1 aufgrund des Scharniers 10 aufklappen, wobei der Schwenkwinkel ca. 140° beträgt. In dieser Stellung kann dann die Bodenwand 11 entnommen werden, so daß sämtliche Komponenten frei zugänglich sind. Es ist jedoch auch möglich, das Gehäuseteil 4 aus dem Scharnier 10 auszuhaken und die Steckverbindung 48 zu lösen, so daß auf einfache Weise ein Austausch oder eine Reparatur erfolgen kann.

Das Gehäuse 1, insbesondere der Schaltungs-Aufnahmeraum 6 ist hermetisch abgeschlossen. Selbst wenn aufgrund einer Undichtigkeit der Kabeleinführung 26 Feuchtigkeit eindringen sollte, so verbleibt diese im Anschlußraum 7, der keine empfindlichen Bauelement aufweist. Das ausgeklügelte Dichtungssystem garantiert einen hohen Schutzgrad, der eine freie Rahmenmontage zuläßt. Aufgrund der metallischen Druckgußteile des Gehäuses 1 ist eine hinreichende elektromagnetische Abschirmung gewährleistet, wobei störstrahlungsträchtige Bauelemente, wie Entstördrosseln, Kondensatoren und Filter, in einem besonderen Raum, nämlich dem Vorraum 53 untergebracht sind.

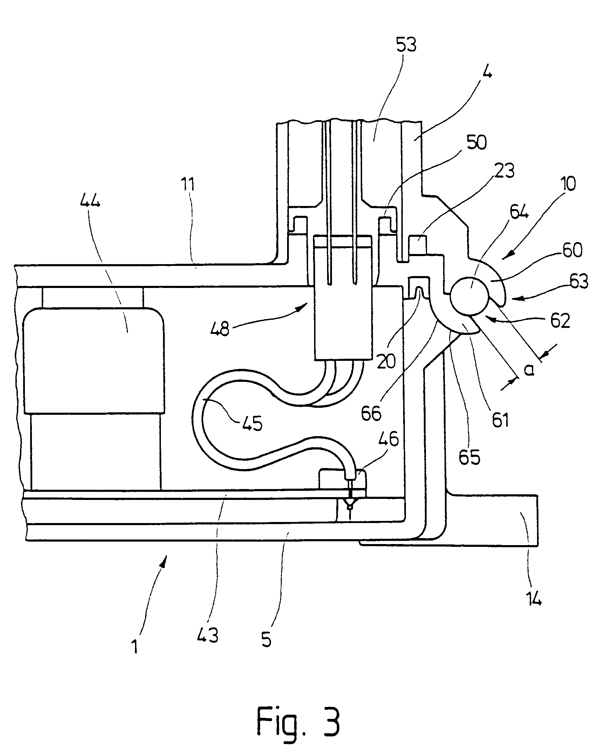

Die Figur 3 zeigt das Gehäuse 1 im Bereich des Scharniers 10 nach einem weiteren Ausführungsbeispiel. Sowohl das erste Gehäuseteil 4 als auch die Bodenwand 11 weisen Fortsätze 60, 61 auf, die eine mit Maulöffnung 62 versehene Scharniergabel 63 bilden. Die Scharniergabel 63 greift an einem Scharnierzapfen 64 des zweiten Gehäuseteils 5 an. In dem geschlossenen Zustand des Gehäuses 1 der Figur 3 liegt die Außenseite 65 des Fortsatzes 61, die einen bogenförmigen Verlauf aufweist, einer formangepaßten Lagerfläche 66 des Gehäuseteils 5 mit geringem Spiel gegenüber. In der in Figur 3 wiedergegebenen Stellung ist daher ein Durchtritt des Scharnierzapfens 64 durch die Maulöffnung 62 verhindert.

Erfolgt jedoch ein Aufklappen des Gehäuses 1, bei dem die Bodenwand 11 und das erste Gehäuseteil 4 gemeinsam relativ zum zweiten Gehäuseteil 5 verschwenkt werden (z. B. um 45°), so weist die eine Schlitzbreite a aufweisende Maulöffnung 62 nach unten und die Außenseite 65 des Fortsatzes 61 wird von der Lagerfläche 66 freigegeben, so daß der Scharnierzapfen 64 die Scharniergabel 63 passieren und das Gehäuse 1 zerlegt werden kann. Durch geeignete konstruktive Maßnahmen läßt sich auch ein anderer Trennwinkel als 45° realisieren. Der Scharnierzapfen 64 ist vorzugsweise einstückig an dem zweiten Gehäuseteil 5 ausgebildet. Dieses gilt ebenfalls für die Fortsätze 60 und 61 am ersten Gehäuseteil 4 bzw. der Bodenwand 11.

## Patentansprüche

1. Gehäuse für eine elektronische Schaltung, insbesondere für eine Steuergerätelektronik einer Brennkraftmaschine eines Fahrzeugs, mit zwei voneinander trennbaren Gehäuseteilen (4, 5), von denen das eine, erste Gehäuseteil (4) den Schaltungs-Aufnahmeraum (6) aufweist und das andere zweite Gehäuseteil (5) die Anschlußvorrichtung für eine lösbare elektrische Verbindung von Informations- und Versorgungsleitungen aufnimmt, dadurch gekennzeichnet, daß das zweite Gehäuseteil (5) einen Anschlußraum (7) für die Anschlußvorrichtung (33) und einen Verteilerraum (8) aufweist und daß das erste Gehauseteil (4) von einer Bodenwand (11) abgeschlossen ist, die im geschlossenen Zustand des Gehäuses das zweite Gehäuseteil (5) verschließt.

2. Gehäuse nach Anspruch 1, dadurch gekennzeichnet, daß die beiden Gehäuseteile (4, 5) über ein Scharnier (10) verbunden sind.

3. Gehäuse nach einem der vorhergehenden Ansprüche, **dadurch gekennzeichnet**, daß der Anschlußraum (7) vom Verteilerraum (8) durch eine Trennwand (36) abgeteilt ist, die von Kontaktanschlüssen (32) der abgedichteten Anschlußvorrichtung (33) durchsetzt wird.

4. Gehäuse nach einem der vorhergehenden Ansprüche, **dadurch gekennzeichnet**, daß die Kontaktanschlüsse (32) direkt mit einer im Verteilerraum (8) angeordneten Platine (43) verbunden sind.

5. Gehäuse nach einem der vorhergehenden Ansprüche, **dadurch gekennzeichnet**, daß die beiden Gehäuseteile (4,5) zwei Gehäuseebenen (12,13) bilden.

6. Gehäuse nach einem der vorhergehenden Ansprüche, **dadurch gekennzeichnet**, daß das zweite Gehäuseteil (5) eine wannenförmige Gestalt aufweist und von der Bodenwand (11) des ersten Gehäuseteils (4) verschließbar ist.

7. Gehäuse nach einem der vorhergehenden Ansprüche, **dadurch gekennzeichnet**, daß zwischen den beiden Gehäuseteilen (4,5) Dichtungen (20,23,50) angeordnet sind.

8. Gehäuse nach einem der vorhergehenden Ansprüche, **dadurch gekennzeichnet**, daß die Bodenwand (11) des ersten Gehäuseteils (4) herausnehmbar ausgebildet ist.

9. Gehäuse nach einem der vorhergehenden Ansprüche, **dadurch gekennzeichnet**, daß die Bodenwand (11) über Dichtungen (23,50) mit dem übrigen ersten, ebenfalls wannenförmigen Gehäuseteil (4) verbunden ist.

10. Gehäuse nach einem der vorhergehenden Ansprüche, **dadurch gekennzeichnet**, daß das Scharnier (10) die beiden wannenförmigen Gehäuseteile (4,5) im Bereich einer Seitenwand (9) des Gehäuses (1) verbindet.

11. Gehäuse nach einem der vorhergehenden Ansprüche, **dadurch gekennzeichnet**, daß die Scharnierhälften des Scharniers (10) in Offenstellung voneinander gelöst werden können.

12. Gehäuse nach einem der vorhergehenden Ansprüche, **gekennzeichnet durch** eine vom Verteilerraum (8) zum Schaltungs-Aufnahmeraum (6) führende, abgedichtete, elektrische Steckverbindung (48).

13. Gehäuse nach einem der vorhergehenden Ansprüche, **dadurch gekennzeichnet**, daß die Steckverbindung (48) ein Kontakt- und ein Gegenkontaktelement (47,49) aufweist und daß das Kontaktelement (47) über flexible, zugentlastete Leitungen (45) an die Platine (43) angeschlosssen ist.

14. Gehäuse nach einem der vorhergehenden Ansprüche, **dadurch gekennzeichnet**, daß das Gegenkontaktelement (49) in einem elektrisch abgeschirmten Vorraum (53) des ersten Gehäuseteils (4) angeordnet ist.

15. Gehäuse nach einem der vorhergehenden Ansprüche, **dadurch gekennzeichnet**, daß der Vorraum (53) störstrahlungsträchtige Bauelemente aufnimmt.

16. Gehäuse nach einem der vorhergehenden Ansprüche, **dadurch gekennzeichnet**, daß die Informations- und Versorgungsleitungen (27) über eine abgedichtete, zugentlastete Kabeleinführung (26) in den Anschlußraum (7) geführt sind.

17. Gehäuse nach einem der vorhergehenden Ansprüche, **dadurch gekennzeichnet**, daß die Gehäuseteile (4,5) als metallische Druckgußteile ausgebildet sind.

## Claims

1. Housing for an electronic circuit, particularly for controller electronics of an internal combustion engine of a vehicle, having two housing parts (4, 5) which can be separated from one another and one first housing part (4) of which exhibits the circuit receiving space (6) and the other second housing part (5) of which accommodates the connecting device for a detachable electrical connection of information and supply lines, characterized in that the second housing part (5) exhibits a connection space (7) for the connecting device (33) and a distributor space (8) and in that the first housing part (4) is closed off by a bottom wall (11) which closes the second housing part (5) in the closed state of the housing.

2. Housing according to Claim 1, characterized in that the two housing parts (4, 5) are connected via a hinge (10).

3. Housing according to one of the preceding claims, characterized in that the connection space (7) is divided from the distributor part (8) by a partition (36) through which contact terminals (32) of the sealed connecting device (33) pass.

4. Housing according to one of the preceding claims, characterized in that the contact terminals (32) are connected directly to a board (43) arranged in the distributor space (8).

5. Housing according to one of the preceding claims, characterized in that the two housing parts (4, 5) form two housing planes (12, 13).

6. Housing according to one of the preceding claims, characterized in that the second housing part (5) exhibits a tub-shaped form and can be closed by the bottom wall (11) of the first housing part (4).

7. Housing according to one of the preceding claims, characterized in that seals (20, 23, 50) are arranged between the two housing parts (4, 5).

8. Housing according to one of the preceding claims, characterized in that the bottom wall (11) of the first housing part (4) is constructed to be removable.

9. Housing according to one of the preceding claims, characterized in that the bottom wall (11) is connected to the other first, also tub-shaped housing part (4) via seals (23, 50).

10. Housing according to one of the preceding claims, characterized in that the hinge (10) connects the two tub-shaped housing parts (4, 5) in the area of a side wall (9) of the housing (1).

11. Housing according to one of the preceding claims, characterized in that the hinge halves of the hinge (10) can be detached from one another in the open position.

12. Housing according to one of the preceding claims, characterized by a sealed electrical plug connection (48) leading from the distributor space (8) to the circuit receiving space (6).

13. Housing according to one of the preceding claims, characterized in that the plug connection (48) exhibits a contact and a counter-contact element (47, 49) and in that the contact element (47) is connected to the board (43) via flexible strain-relieved lines (45).

14. Housing according to one of the preceding claims, characterized in that the counter-contact element (49) is arranged in an electrically shielded antichamber (43) of the first housing part (4).

15. Housing according to one of the preceding claims, characterized in that the antichamber (53) accommodates components which are susceptible to radiated interference.

16. Housing according to one of the preceding claims, characterized in that the information and supply lines (27) are conducted into the connection space (7) via a sealed strain-relieved cable lead-in (26).

17. Housing according to one of the preceding claims, characterized in that the housing parts (4, 5) are constructed as diecast metallic parts.

## Revendications

1. Boîtier pour un circuit électronique, en particulier pour l'électronique d'un appareil de commande du moteur à combustion interne d'un véhicule, avec deux parties de boîtier (4, 5) pouvant être séparées l'une de l'autre, dont l'une, la première partie de boîtier (4) fournit la chambre destinée à recevoir le circuit (6) et l'autre partie, la deuxième partie de boîtier (5) reçoit le dispositif de raccordement pour établir une liaison électrique détachable avec des fils d'information et des fils d'alimentation, caractérisé en ce que la deuxième partie de boîtier (5) présente une chambre de raccordement (7) pour le dispositif de raccordement (33) et pour une chambre de distributeur (8), et en ce que la première partie de boîtier (4) est fermée par une paroi de fond (11), qui ferme la seconde partie de boîtier (5) quand le boîtier est dans l'état fermé.

2. Boîtier selon la revendication 1, caractérisé en ce que les deux parties de boîtier (4, 5) sont reliées au moyen d'une charnière (10).

3. Boîtier selon l'une des revendications précédentes, caractérisé en ce que le boîtier de raccordement (7) est séparé de la chambre de distributeur (8) par une cloison de séparation (36) qui est traversée par des raccordements aux contacts (32) du dispositif de raccordement (33) rendu étanche.

4. Boîtier selon l'une des revendications précédentes, caractérisé en ce que les raccords aux contacts (32) sont directement reliés à une platine (43) disposée dans la chambre de distributeur (8).

5. Boîtier selon l'une des revendications précédentes, caractérisé en ce que les deux parties de boîtier (4, 5) forment deux niveaux de boîtier (12, 13).

6. Boîtier selon l'une des revendications précédentes, caractérisé en ce que la deuxième partie de boîtier (5) présente une configuration en forme de cuvette et peut être fermée par la paroi de fond (11) de la première partie de boîtier (4).

7. Boîtier selon l'une des revendications précédentes, caractérisé en ce qu'entre les deux parties de boîtier (4, 5) on dispose des joints d'étanchéité (20, 23, 50).

8. Boîtier selon l'une des revendications précédentes, caractérisé en ce que la paroi de fond (11) de la première partie de boîtier (4) est constituée de façon extractible.

9. Boîtier selon l'une des revendications précédentes, caractérisé en ce que la paroi de fond (11) est reliée au reste de la première partie de boîtier (4), également en forme de cuvette, par l'intermédiaire de joints d'étanchéité (23, 50).

10. Boîtier selon l'une des revendications précédentes, caractérisé en ce que la charnière (10) relie les deux parties de boîtier (4, 5) en forme de cuvette dans la zone d'une paroi latérale (9) du boîtier (1).

11. Boîtier selon l'une des revendications précédentes, caractérisé en ce que l'on peut séparer l'une de l'autre les moitiés de la charnière (10) quand elle est en position ouverte.

12. Boîtier selon l'une des revendications précédentes, caractérisé par une liaison électrique à enfichage (48) allant de la chambre de distributeur (8) à la chambre servant à recevoir le circuit (6), liaison qui est rendue étanche.

13. Boîtier selon l'une des revendications précédentes, caractérisé en ce que la liaison à enfichage (48) présente un contact et un contact opposé (47, 49) et en ce que le contact (47) est raccordé à la platine (43) au moyen de fils flexibles, libres de toute traction (45).

14. Boîtier selon l'une des revendications précédentes, caractérisé en ce que ce contact opposé (49) est disposé dans une antichambre (53) électriquement blindée, de la première partie de boîtier (4).

15. Boîtier selon l'une des revendications précédentes, caractérisé en ce que l'antichambre (53) reçoit des composants dégageant des rayonnements parasites.

16. Boîtier selon l'une des revendications précédentes, caractérisé en ce qu'on fait passer les fils d'information et les fils d'alimentation (27) par un introducteur de câble rendu étanche, libéré de tout effort de traction, entrant dans la chambre de raccordement (7).

17. Boîtier selon l'une des revendications précédentes, caractérisé en ce que les parties de boîtier (4, 5) sont constituées sous la forme de pièces métalliques moulées sous pression.
